# EUROPEAN PATENT APPLICATION

(11) **EP 2 216 289 A1**
(43) Date of publication of application: **11.08.2010**
(21) Application number: 07823028.1
(22) Date of filing: 02.11.2007
(51) Int. Cl.: B81C 1/00, B81B 3/00

(54) **METHOD FOR THE PRODUCTION OF MICRO/NANOFLUIDIC DEVICES FOR FLOW CONTROL AND RESULTING DEVICE**

(71) Applicant: Ikerlan Centro de Investigaciones Tecnológicas, S.Coop., 20500 Mondragón-Guipúzkoa (ES)
(72) Inventor: FERNÁNDEZ LEDESMA, Luis José, E-20500 Mondragón (ES); TIJERO SERNA, María, E-20500 Mondragón (ES)
(74) Representative: Carvajal y Urquijo, Isabel
(86) International application number: PCT/ES2007/000622
(87) International publication number: WO 2009/056654

(57) **Abstract**

**SUMMARY**

The present invention refers to a procedure for the manufacture of micro-nanofluidic devices for flow control such as microvalves, micropumps and flow regulators, using a photodefinable polymer and an elastomer as structural materials and to the micro-nanofluidic devices for flow control obtained by said procedure.

## Description

### Field of the invention

The present invention refers to the field of micro-nanofluidic control devices; specifically, it refers to membrane microvalves, pneumatic micropumps and flow regulators, manufactured with polymeric materials.

### State of the Art

The first valve with micrometric dimensions was introduced in 1979 by Ferry S. C. [1], and even though in the last 20 years there has been great progress there are still many improvements to be made as regards the characteristics of the microvalves [2].

Recently, a great effort has been made in the development of mechanical microvalves to try to attain a short response time (ms), with low losses (□1/min.) when high pressures are used (bar). Most devices developed so far have been produced using MEMS (Micro-electro-mechanical Systems) technology.

As regards the actuation methods, the most important ones are magnetic, electrical, piezoelectric and thermal ones. However, none of them can guarantee on its own the good operation of the microvalve, since they ultimately depend on the final application it is destined for.

The magnetic actuation is usually carried out through the use of solenoids to move membranes or pistons [1, 3-6], since they can generate great forces and fast responses. However, for miniaturized structures, the electrostatic actuation is more attractive. Nevertheless, in order to obtain great forces and displacements it is necessary to use high voltages [7-10], which is not always possible or convenient.

The piezoelectric actuation enables to obtain very high forces but very small displacement even for high voltage levels [11-14].

The thermal actuation can also produce elevated forces, but its relatively slow response and the heat dissipation produced may advise against its use in many cases [15-18].

Finally, the use of an external actuation method can be useful to comply with these requirements, although it can comprise the miniaturization of the device (pressure through an external pin) or its portability (pneumatic pressure) [19-25].

Through the use of the same techniques detailed in the previous paragraph, it is possible to carry out the manufacture of the micropumps based on reciprocal displacement. This kind of pumps basically consist of the manufacture of a pumping chamber where the volume to be displaced is located, and two microvalves. Through a cyclic actuation of the valves and the pumping chamber, it is possible to attain a net flow in the required direction [26-30].

The most promising applications for the microvalves and micropumps are biotechnology and miniaturized chemical laboratories. The turning on and off of the microfluidic channels, or the sealing of biomolecules and chemical agents without losses, even when high pressures are applied, are critical properties to guarantee the good functioning of the biochemical chip. The loss of biological or chemical agents, and their migration to different areas of the chip could lead to its contamination and have a negative influence on the reactions to be produced. The sealing of the reaction chambers is also essential to prevent the evaporation of agents and the generation of air bubbles if high temperature is used.

Some polymeric materials, as they are biocompatible, have an important advantage. Besides, their great elasticity turns them into excellent candidates for membranes which can displace along great distances (up to hundreds of micrometers). Therefore, they are materials which are optimal to manufacture microvalves, micropumps and flow regulators based on active designs by displacement.

As regards the polymeric microvalves, although there have been presented works in which the actuation is carried out by different principles, the most frequently used one is the external pneumatic actuation (presence of air pressure or vacuum). This occurs since this kind of actuation has advantages to obtain valves without losses under high pressure, although the miniaturization may be difficult. In case of micropumps, it is necessary to highlight that the only micropump which is commercially extended is made through plastic microinjection (thinXXS GMBH, Germany).

In great part of the aforementioned works based on polymers, the material used as membrane is an elastomer, being PDMS the most frequently used one. Its low Young's modulus makes it the ideal material to be actuated. Besides, its elasticity can be varied according to the curing agent percentage added to the final mixture [31]. However, in cases where the PDMS is also used as structural material, the final chip ends up being mechanically unstable (too flexible). In order to prevent this, substrates such as glass or silicon are used, which considerably increase the final price of the chip. Moreover, the use of PDMS as structural material of the channels makes these suffer deformations due to the pressure of the fluid going through them, which affects the fluidic control of the device [32].

Therefore, there is a need to find a micro-nanofluidic control device which work is not limited by manufacturing materials.

### Description of the invention

The present invention provides a procedure for the manufacture of microvalves, micropumps and polymeric flow regulators using a photo definable polymer and an elastomer as structural materials so that the final device is not deformed by the fluid pressure, also having a mobile membrane with a low Young's modulus, creating a broad range of possibilities for its actuation.

In a first aspect, the present invention refers to a procedure for the manufacture of micronanofluidic devices for flow control, **characterized in that** it comprises the following stages:
a) Deposition and definition of a photodefinable polymeric layer, on an independent substrate surface (wafer 1),
b) Deposition and definition of a photodefinable polymeric layer, on an independent substrate surface (wafer 2) covered by a non-stick material,
c) Sealing of the wafer 1 and the wafer 2, facing said wafers the face containing the photodefinable polymeric material,
d) Removal of the wafer 2 covered by non-stick material,
e) Deposition of a metallic layer on the polymeric layer resulting from stage d),
f) Deposition and definition of a photodefinable polymeric layer on an independent substrate surface (wafer 3) covered by a non-stick material,
g) Sealing of the wafer 1 and the wafer 3, facing said wafers the face containing the photodefinable polymeric material,
h) Removal of the wafer 3 covered by non-stick material,
i) Spinning and curing of an elastomeric layer on an independent substrate of non-stick material with the elastomer (wafer 4),
j) Sealing of the wafer 1 and the wafer 4 facing the photodefinable polymeric material and the elastomeric layer,
k) Removal of the wafer 4
l) Deposition and definition of a crystalline structure material on the elastomer face which is bare at stage K),
m) Deposition and definition of a photodefinable polymeric layer on an independent substrate surface (wafer 5) covered by a non-stick material,
n) Sealing of wafer 1 and wafer 5, facing said wafers the face containing the elastomer and the photodefinable polymeric material respectively,
o) Removal of the wafer 5 covered by non-stick material,
p) Deposition and definition of a photodefinable polymeric layer on an independent substrate surface (wafer 6) covered by a non-stick material,
q) Sealing of wafer 1 and wafer 6, facing said wafers the face containing the photodefinable polymeric material,
r) Removal of the wafer 6 covered by non-stick material.

In a particular aspect, the procedure of the present invention comprises a stage previous to stage a) consisting on the deposition and definition of a metallic layer on the surface of the independent substrate (wafer 1). Particularly, the metallizing of the present invention is carried out by techniques known by an expert in the art, such as cathode sputtering, evaporation or deposition.

In another particular aspect of the present invention, the crystalline material deposited at stage k) is a metal.

In another particular aspect of the present invention, the crystalline material deposited at stage k) is a piezoelectric material.

In another particular aspect of the present invention, the sealing at stages c), g), j), n) and q) is carried out through the application of pressure and temperature.

In another particular aspect of the present invention, the sealing at stage n) comprises a previous treatment with oxygen plasma.

In another particular aspect of the present invention, the photodefinable polymeric layer deposited at stages a), b), f), m) and p) consists of the photoresin SU-8.

In another particular aspect of the present invention, at stages a), b), f), m) or p) more than one photodefinable polymeric layer is deposited and defined.

In another particular aspect of the present invention, the elastomer layer is PDMS.

In another particular aspect of the present invention, the micro-nanofluidic device for flow control is a micropump.

In another particular aspect of the present invention, the micro-nanofluidic device for flow control is a microvalve.

In another particular aspect of the present invention, the micro-nanofluidic device for flow control is a flow regulator.

In a second aspect, the present invention refers to a micro-nanofluidic device for flow control obtained through the previously described procedure.

### Brief description of the drawings

Figure 1 shows the contact angle measured for different plasma configurations.
Figure 2 shows SEM images of the interface between SU-8 (1) (an example of photodefinable polymer) and PDMS (2) (an example of elastomer).
Figure 3 shows the design proposed as valve and flow regulator, a) open cross section, b) closed cross section, c) open upper view and d) closed upper view, as it can be seen, two channels absorbed in polymeric layers which are connected through two open inlets located in a common chamber. In said chamber the elastomeric membrane (3) is located through the pasting process described before at a height determined by a new polymer layer.
Figure 4 shows the cross section of a microfluidic device (microvalve) with different distances between the elastomeric membrane (3) and the floor.
Figure 5 shows the cross section of a microfluidic pump in a cyclical series of actuations a), b) and c), where it can be seen a central chamber (5) and two valves (4) at the ends.
Figure 6 shows the general scheme of the procedure for the manufacture of microvalves (4), micropumps (6) and flow regulator (7).
Figure 7 shows a flow regulator comprising an extra electrode (8) in the upper part.

### Detailed description of the invention

The procedure of the present invention is based on the use of photolithography and sealing techniques at temperatures under 100°C of thermosetting polymeric materials such as SU-8 (US Patent 4,882,245, Nov 21st, 1989), which allow the manufacture of very high resolution microfluidic structures (between 500 nanometers at 500 micron width and between 1 and 200 micron height) on rigid substrates with good bonding (for the final substrate of the devices), or on rigid substrates on which a plastic material on which SU-8 has slow bonding has been deposited, pasted or laminated, in a reversible manner, such as polyimide (kapton), PET or Mylar. These polymeric materials of low bonding to SU-8 enable us to release the chips from the substrate on which new layers of SU-8 have been added. Besides, in the present invention there have been developed manufacturing processes to integrate elastomeric membranes (PDMS) and methods for metallizing the different layers.

The manufacturing process of the invention started with the deposit of SU-8 photoresin through the spinning on a transparent rigid wafer. It can be a glass, or polymeric (PMMA, COC, etc.) wafer, but in this concrete case a PMMA wafer was used. The thickness of the layer deposited depends on the speed and the spinning time, and on the formulation of the SU-8 (quantity of solvent inserted on the polymer), being possible the spinning of layers of 200 nanometer thickness up to 500 micron thickness. In this case layers of 20 and 40 micron thickness have been used. If it was desired to obtain thicker layers, the spinning process was repeated until the required thickness was obtained. Next, these layers were submitted to a thermal process (soft bake) at a temperature between 65 and 100°C, during 7 to 30 minutes, according to the temperature and thickness used. In this process the rest of the solvent was evaporated and the resin deposited was standardized. Once this thermal process has ended, the polymer deposited was microstructured using standard photolithography techniques. With the help of a mask placed on top of the wafer, the areas to be kept are exposed to ultraviolet light. The dose used was 140mJ/cm². Later, the layers were submitted to a thermal process for the partial curing of the photoresin. This process occurred at a temperature between 65 and 100°C, during 1 to 10 minutes, according to the temperature and thickness used. Once room temperature was reached, a chemical development of the non-exposed areas was performed, defining in the photoresin the forms drawn on the mask used for the ultraviolet lighting process. This development was carried out with the standard developer of the SU-8 photoresin (propylene glycol monomethyl ether acetate, PGMEA).

The SU-8 layer definition process was also carried out in PMMA wafers on which a material with low bonding with SU-8 has been deposited in a reversible manner. These layers have the purpose of being added to the final substrate by means of a sealing process. This sealing has already been detailed in literature, both when silicon and glass wafers [33-34] are used and when PMMA wafers are used [35]. However, in both cases they are limited to SU-8 layers defined with thermal treatments which are at around 90°C, using a pressure of 3.25 bar when silicon or Pyrex are used as substrate and 3.75 bar when PMMA is used. In the present invention it was also carried out pasting of the SU-8 layers and their definition process was carried out through thermal processes which range from 65°C to 120°C. The pasting can be performed at temperatures as low as 75°C, and as high as 120°C. The result in all cases is a percentage of pasting area of 100%.

Once the sealing process has ended, the devices are submerged in an isopropanol bath and submitted to ultrasound for 1 minute. This bath has two functions, the releasing of the Kapton, PEB or Mylar layers of the rigid substrates and the cleaning of the devices.

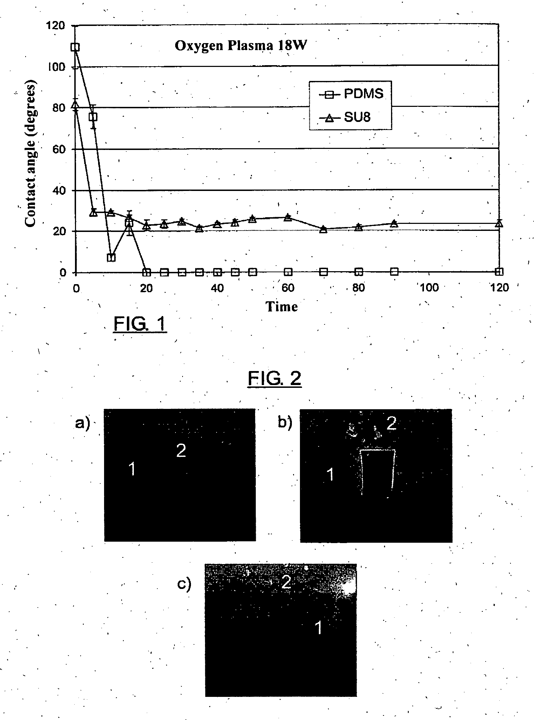

During the manufacture of the devices described in the present invention it is required the sealing of SU-8 layers with flexible membranes based on elastomers. In this particular case, PDMS has been used, which was spinned in PMMA wafers until the desired thickness was obtained and left for curing (24 hours at room temperature). Later, both the wafer with SU-8 and the one containing PDMS are treated with oxygen plasma to boost its bonding. The specific conditions used where 2 minutes at 18W, although more combinations of power and time are also valid (see figure 1). The sealing is carried out under the same conditions under which the pasting of SU-8 with SU-8 is carried out [36]. Finally, the PMM substrate is removed manually and cleanly thanks to the low bonding between PDMS and PMMA.

The pasting of the photodefinable polymer and elastomer to which the present invention refers is based on the use of previous treatment with oxygen plasma in both materials. They are later put in contact through pressure and temperature. During the plasma treatment both the elastomer and the photodefinable polymer undergo a superficial molecular breakdown, increasing its possibilities for a possible union between them. Both materials experience an increase of hydrophilicity according to the success of the plasma treatment. Therefore, the effect of this superficial treatment can be measured indirectly through the measurement of the angle of contact of one drop of water deposited on it. In this way, it is possible to calculate the optimum parameters for the plasma treatment to carry out the sealing [33].

Once both the photodefinable polymer and the elastomer have been treated with oxygen plasma, both materials are put in contact. At this point, it can be observed that the first bonding starts to occur between the two polymers, although they can still be easily separated probably due to the reduced contact surface. However, when they are submitted to a pressure of 325KPa and to a temperature above 65°C and under 120°C, the pasting becomes irreversible. While applying pressure considerably increases the contact surface between the,two polymers, the thermal treatment acts as catalyst for the polymerization of the polymer with the elastomer. The pasting strength was tested trying to separate both polymers applying air pressure. Both, when the polymer is pasted to the elastomer excluding the oxygen plasma, and when the application of pressure and/or temperature is eliminated, both materials are separated easily. However, when the photodefinable polymer and the elastomer are submitted to the oxygen plasma and to the action of pressure and temperature, their separation through air pressure was impossible. By contrast, it can be observed that the elastomeric membrane breaks instead of removing itself from the polymer (2.5 bar when the elastomer consists of a PDMS layer with a thickness of about 80µm and a mixture of 1:10 with respect to the curing agent), thus proving that the pasting is irreversible.

Figure 2 shows SEM images of the interface between SU-8 (an example of photodefinable polymer) and PDMS (an example of elastomer). It is therefore proved the integration of an elastomer and a photodefinable polymer for the manufacture of microfluidic devices.

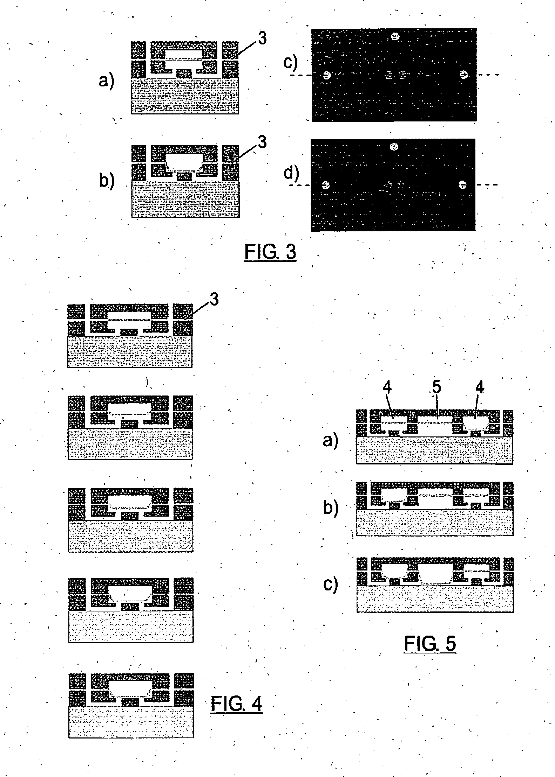

In case of using the design of figure 3 as a valve, the elastomeric membrane is actuated until it is crashed against the floor. As a result, the two holes that allow the flow from one channel to the next are blocked and the flow through the channels stops. However, when the actuation on the elastomer is released it goes back to its original position, allowing the flow to go through again. It is therefore a normally open valve. The design in figure 3 can be also used for the manufacture of flow regulators.

In this case the elastomeric membrane is actuated so that its distance is reduced with respect to the floor without blocking the inlets of the two channels, as shown in figure 4. In this way, the flow that goes through the channel is reduced,due to the increase of fluidic resistance generated by the displacement of the elastomeric membrane. The dimensions of the device as regards channel size, connecting holes size and distance between them, determine the range of flow that it can control.

Finally, this technology is also proposed for the manufacture of microfluidic pumps based on reciprocal movement. As shown in figure 5, the pump consists of a chamber containing the liquid to be displaced in each cycle. The displacement of said liquid is based on the same principle previously described, that is, the actuation of an elastomeric membrane. On both sides of the chamber, two valves are used to direct the flow of the liquid. A possible way is the use of a cyclical series of actuations, from which a net flow is obtained in the required direction (see figure 5). However, the use of active valves can be avoided and passive valves can be employed (check valve). Mobile structures made of photodefinable polymer [34-35] can be used to favour the flow in one direction, being necessary the only actuation of the elastomeric membrane.

In case of some kinds of actuation (electric, thermal, magnetic, etc.), the procedure of the invention requires a stage previous to the deposit, and definition of the photodefinable polymeric layer (SU-8), of metallic material deposition. These depositions can be by evaporation techniques or by cathode sputtering, being possible to use deposition techniques if thicknesses of around dozens of microns are required such as in the case of magnetic field actuation. The definition of said layers can be easily made through a physical mask ("shadow mask"), which is placed on top of the wafer where it is desired to deposit the metallic material to allow the deposition only in the desired areas. For said metallizations to have an optimal bonding, the surfaces are treated with oxygen plasma using the data of figure 1.

The steps of the deposition of photodefinable polymer layers can be repeated more than once to obtain greater thicknesses.

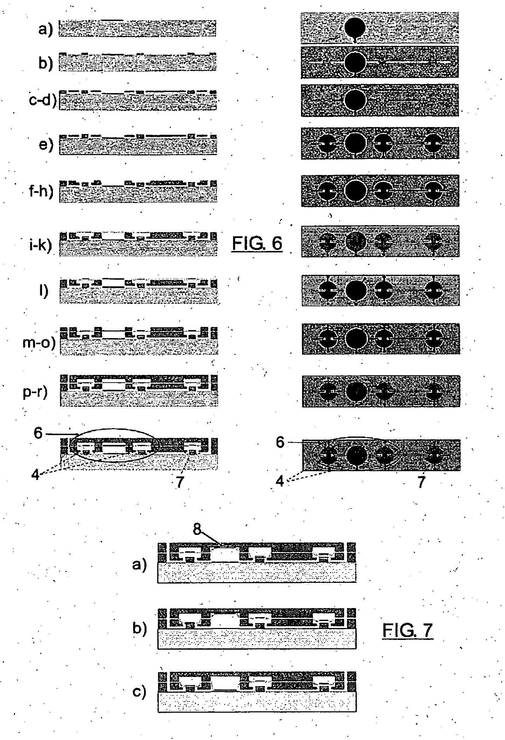

Figure 6 shows the manufacturing scheme as described in the description of the invention section. Although the last two polymer layers and their sealing are only indispensible for pneumatic actuation, it is also advisable to use it in case of actuation through magnetic and electric field as such, as shown in figure 7. In this way, there is an increase of the volume displaced by the pump and the maximum actuation voltage remains constant and independent of the pressure at which the fluid is submitted. Said pressure causes the bulking of the elastomeric membrane and if there is no stop, the voltage required for the actuation of the membrane can be excessively high.

### References

[1] Terry S C, Jeman J H and Angel J B, 1979, A gas chromatographic air analyzer fabricated on a silicon wafer, IEEE Trans. Electro Devices 26 1880-6
[2] Kwang W Oh and Chong H Ahn, 2006, A review of microvalves, J Micromech. Microeng. 16, R13-R39
[3] Yanagisawa K, Kuwano H and Tapo A, 1993, An electromagnetically driven microvalve, Proc. Transducers'93, pp 102-5
[4] Meckes A, Behrens J, Kaysdr O, Benecke W, Becker T and Muller G, 1999, Microfluidic system for the integration and cyclic operation of gas sensors. Sensors Actuators A, 76, 478-83
[5] Bae B, Kee H, Kim S, Lee Y, Sim T, Kim Y and Park K, 2003, In vitro experiment of the pressure regulating valve for a glaucoma impant, J. Micromech. Microeng., 13, 613-9
[6] Bae B, Kim N, Kee H, Kim S-H, Lee Y, Lee S and Park K, 2002, Feasibility test of an electromagnetically driven valve actuator for glaucoma treatment, J. Microelectromech. Syst., 11, 344-54
[7] Sato K and Shikida M, 1994, An electrostatically actuated gas valve with an S-shape film element, J. Micromech. Microeng., 4, 205-9
[8] Goll C, Bacher W, Bustengs B, Maas D, Ruprecht R and Schomburg WK, 1997, An electrostatically actuated polymer microvalve equipped with a movable membrane electrode, J. Micromech. Microeng., 7, 224-6
[9] Robertson J K and Wise K D, 1998, A low pressure micromachined flow modulator, Sensors Actuators A, 71, 98-106
[10] Schaible J, Vollmer J, Zengerle R, Sandmaier H and Strobelt T, 2001, Electrostatic microvalves in silicon with 2-way function for industrial applications, 11th Int. Conf. On Solid-State Sensors and Actuators (Transduciers'01), pp 928/31
[11] Li H Q, Roberts D C, Steyn J L; Turner K T, Yaglioglu O, Hagood N W, Spearing S M and Schmidt M A, 2004, Fabrication of a high frequency piezoelectric microvalve, Sensors Actuators A 111 51-6
[12] Roberts D C, Li H, Steyn J L, Yagliog O and Spearing S M, 2003, A piezoelectric microvalve for compact high-frequencey, high-differential pressure hydraulic micropumping systems, J. Microelectromech. Syst. 12 81-92
[13] Rogge T, Rummler Z and Schomburg W K, 2004, Polymer microvalve with a hydraulic piezo-drive fabricated by the AMANDA process, Sensors Actuators A 110 206-12
[14] Shao P, Rummler Z and Schomburg W K, 2004, Polymer micro piezo valve with a small dead volume, J. Micromech. Microeng. 14 305-9
[15] Rich C A and Wise K D, 2003, A high-flow thermopneumatic microvalve with improved efficiency and integrated state sensing J. Microelectromech. Syst.12 201-8
[16] Ruzzu A, Bade K, Fahrenberg J and Mass D, 1998, Positioning system for catheter tips based on an active microvalve system J. Micromech. Microeng. 8 161-4
[17] Takao H, Miyamura K, Ebi H, Ashiki M, Sawada K and Ishida K, 2005, A MEMS microvalve with PDMS diaphragm and two-chamber configuration of thermo-pneumatic actuator for integrated blood test system on silicon Sensors Actuators A 119 468-75
[18] Ho C-M, Yang X, Grosjean C and Tai Y-C, 1998, A MEMS thermopneumatic silicone rubber membrane valve Sensors Actuators A 64 101-8
[19] Takao H and Ishida M, 2003, Microfluidic integrated circuits for signal processing using analogous relationship between pneumatic microvalve and MOSFET J. Microelectromech. Syst. 12 497-505
[20] Legally E T, Simpson P C and Mathies R A, 2000, Monolithic integrated microfluidic DNA amplification and capillary electrophoresis analysis system Sensors Actuators B 63 138-46
[21] Lagally E T, Medintz I and Mathies R A, 2001, Singlemolecule DNA amplification and analysis in an integrated microfluidic device Anal. Chem. 73 565-70
[22] Lagally E T, Emrich C A and Mathies R A, 2001, Fully integrated PCR-capillary electrophoresis microsystem for DNA analysis Lab Chip 1 102-7
[23] Grover W H, Skelley A M, Liu C N, Lagally E T and Mathies R A, 2003, Monolithic membrane valves and diaphragm pumps for practical large-scale integration intro glass microfluidic devices Sensors Actuators B 89 315-23
[24] Lagally E T, Scherer J R, Blazej R G, Toriello N M, Diep B A, Ramchandani M, Sensabaugh G F, Riley L W and Mathies R A, 2004, Integrated portable genetic analysis Microsystem for pathogen/infectious disease detection Anal. Chem. 76 3162-70
[25] Go J S and Shoji S, 2004, A disposable, dead volume-free and leak-free in-plane PDMS microvalve Sensors Actuators A 114 438-44
[26] Chun-Wei Huang, Song-Bin Huang and Gwo-Bin Lee, 2006, Pneumatic micropumps with serially connected actuation chambers, J. Micromech. Microeng. 16 2265-2272
[27] Ok Chang Jeong, Sin Wook Park, Sang Sik Yang, James Jungho Pak, 2005, Fabrication of a peristaltic PDMS micropump, Sensors and Actuators A 123-124 453-458
[28] Charles W. Frevert, Gregory Boggy, Thomas M. Keenan and Albert Folch, 2006, Measurement of cell migration in response to an evolving radial chemokiine gradient triggered by a microvalve, Lab. Chip 6 849-856
[29] M C Tracey, I D Johnston, J B Davis and C K L Tan, 2006, Dual independent displacement-amplified micropumps with a single actuator J Micromech. Microeng. 16 1444-1452
[30] Walker Inman, Karel Domansky, James Serdy, Bryan Owens, David Trumper and Linda G Griffith, 2007, Design, modeling and fabrication of a constant flow pneumatic micropump J. Micromech. Microeng. 17 891-899
[31] Deniz Armandi, Chang Liu and Narayan Aluru, 1999, Reconfigurable fluid circuits by PDMS elastomer micromachining, MEMS International Conference, 222-227
[32] Thomas Gervais, Jamil El-Ali, Axel Guntherb and Klavs F. Jensen, 2006, Flow-induced deformations of shallow microfluidic channels Lab on a Chip 6 500-507
[33] Shantanu Bhattacharya, Arindom Data, Jordan M. Berg, and Shubhra Gangopadhyay, 2005, Studies on Surface Wettability of Poly(Dimethyl) Siloxane(PDMS) and Glass Under Oxygen-Plasma Treatment and Correlation With Bond Strength, J Microelectromech. Syst 14, 590-597
[34] M. Agirregabiria, F. J. Blanco, J. Berganzo, M. T. Arroyo, A. Fullaondo, K. Mayora and J. M. Ruano-Lopez, 2005, Fabrication of SU-8 multilayer microstructures based on successive CMOS compatible adhesive bonding and releasing steps Lab Chip 5 545-552
[35] F J Blanco, M Agirregabiria, J Garcia, J Berganzo, M Tijero, M T Arroyo, J M Ruano, I Aramburu and Kepa Mayora, 2004, Novel three-dimensional embedded SU-8 microchannels fabricated using a low temperatura full wafer adhesive bonding, J. Micromech. Microeng. 14 1047-1056
[36] M T Arroyo, L J Fernandez, M Agirregabiria, N Ibañez, J Aurrekoetxeal and F J Blanco, 2007, Novel all-polymer microfluidic devices monolithically integrated within Metallica electrodes for SDS-CGE of proteins J. Micromech. Microeng. 17 1289-1298

## Claims

1. Procedure for the manufacture of micro-nanofluidic devices for flow control **characterized in that** it comprises the following stages:
a) Deposition and definition of a photodefinable polymeric layer, on an independent substrate surface (wafer 1),
b) Deposition and definition of a photodefinable polymeric layer, on an independent substrate surface (wafer 2) covered by a non-stick material,
c) Sealing of the wafer 1 and the wafer 2, facing said wafers the face containing the photodefinable polymeric material,
d) Removal of the wafer covered by non-stick material,
e) Deposition of a metallic layer on the polymeric layer resulting from stage d),
f) Deposition and definition of a photodefinable polymeric layer on an independent substrate surface (wafer 3) covered by a non-stick material,
g) Sealing of the wafer 1 and the wafer 3, facing said wafers the face containing the photodefinable polymeric material,
h) Removal of the wafer covered by non-stick material,
i) Spinning and curing of an elastomeric layer on the polymeric layer resulting from stage h),
j) Sealing of the elastomeric layer on the wafer,
k) Deposition and definition of a crystalline structure material on the elastomer deposited at stage j),
l) Deposition and definition of a photodefinable polymeric layer on an independent substrate surface (wafer 4) covered by a non-stick material,
m) Sealing of wafer 1 and wafer 4, facing said wafers the face containing the photodefinable polymeric material,
n) Deposition and definition of a photodefinable polymeric layer on an independent substrate surface (wafer 5) covered by a non-stick material,
o) Sealing of wafer 1 and wafer 5, facing said wafers the face containing the photodefinable polymeric material,

2. Procedure for the manufacture of micro-nanofluidic devices for flow control according to claim 1, **characterized in that** it comprises a stage previous to stage a) consisting on the deposition and definition of a metallic layer on the independent
substrate surface (wafer 1).

3. Procedure for the manufacture of micro-nanofluidic devices for flow control according to any of the claims 1 to 2, wherein the crystalline material deposited at stage k) is a metal.

4. Procedure for the manufacture of micro-nanofluidic devices for flow control according to any of the claims 1 to 2, wherein the crystalline material deposited at stage k) is a piezoelectric material.

5. Procedure for the manufacture of micro-nanofluidic devices for flow control according to any of the preceding claims, wherein the sealing at stages c), g), j), m) and o) is carried out through pressure and temperature.

6. Procedure for the manufacture of micro-nanofluidic devices for flow control according to any of the preceding claims, wherein the sealing at stage j) comprises the previous treatment with oxygen plasma.

7. Procedure for the manufacture of micro-nanofluidic devices for flow control according to any of the preceding claims, wherein the photodefinable polymeric layer deposited at stages a), e), f), l) and n) consist of the photoresin SU-8.

8. Procedure for the manufacture of micro-nanofluidic devices .for flow control according to any of the preceding claims, wherein at stages a), e), f), l) or n) more than one photodefinable polymeric layer is deposited and defined.

9. Procedure for the manufacture of micro-nanofluidic devices for flow control according to any of the preceding claims, wherein the elastomeric layer is PDMS.

10. Procedure for the manufacture of micro-nanofluidic devices for flow control according to any of the preceding claims, wherein the micro-nanofluidic devices are micropumps, microvalves and/or flow regulators.

11. Micro-nanofluidic device for flow control obtained by the procedure described according to any of the claims 1-10.
